# EUROPEAN PATENT APPLICATION

(11) **EP 4 270 465 A1**
(43) Date of publication of application: **01.11.2023**
(21) Application number: 21915173.5
(22) Date of filing: 22.12.2021
(51) Int. Cl.: H01L 23/02, H01L 23/04, H01L 23/12, H05K 1/02, H05K 3/46

(54) **SEMICONDUCTOR PACKAGE AND SEMICONDUCTOR ELECTRONIC DEVICE**

(30) Priority: 28.12.2020 JP 2020218246; 22.02.2021 JP 2021025883
(71) Applicant: Kyocera Corporation, Kyoto-shi Kyoto 612-8501 (JP)
(72) Inventor: KON, Tomoya, Kyoto-shi, Kyoto 612-8501 (JP); KITAHARA, Hikaru, Kyoto-shi, Kyoto 612-8501 (JP)
(74) Representative: Viering, Jentschura & Partner mbB Patent- und Rechtsanwälte
(86) International application number: PCT/JP2021/047598
(87) International publication number: WO 2022/145313

(57) **Abstract**

A semiconductor package includes an insulating substrate (11), a pair of signal electrodes (121), a pair of differential lines (14), and a ground conductor. The pair of differential lines (14) are respectively connected to the signal electrodes (121). Each differential line (14) includes a first signal line (142), a second signal line (144), a first via-hole conductor (141), and a second via-hole conductor (143). The ground conductor includes a ground plane (11g), a ground plane (15g), and a ground via-hole conductor (145). The ground plane (15g) sandwiches the first signal line (142) between the ground plane (15g) and the ground plane (11g) and forms a stripline structure. The ground via-hole conductor (145) is located along the second via-hole conductor and forms a coaxial structure. In planar perspective view of the first surface, a position on a plane including the ground plane (11g) including the second end portion (143c) is located in a gap region (11f).

## Description

### TECHNICAL FIELD

The present disclosure relates to a semiconductor package and a semiconductor electronic device.

### BACKGROUND OF INVENTION

In a semiconductor package, signals transmitted and received between signal terminals and electronic components positioned in the internal space of the package are transmitted along signal paths such as signal lines and through conductors (via-hole conductors) of the package. Japanese Unexamined Patent Application Publication No. 2020-53533 discloses a technique for reducing crosstalk caused by interference of radio-frequency signals in 1 to 60 GHz bands between signal lines by using a structure in which a notch is provided in an insulating substrate between electrode conductors for a pair of signal lines configured to carry differential signals, and in which the bottom of the notch serves as a ground plane.

### SUMMARY

### SOLUTION TO PROBLEM

In an aspect of the present disclosure,
a semiconductor package includes an insulating substrate, a pair of first electrodes, a pair of differential lines, and a ground conductor.

The insulating substrate has a first surface and a second surface on an opposite side from the first surface.

The pair of first electrodes are disposed side by side along one edge of the first surface.

The pair of differential lines are respectively electrically connected to the pair of first electrodes and are configured to carry signals.

The insulating substrate includes a first groove located in the first surface and extending between the pair of first electrodes.

Each of the pair of differential lines includes a first signal line, a second signal line, a first connection conductor, and a second connection conductor.

The first signal line is located inside the insulating substrate and extends along the first surface.

The second signal line is located on the second surface.

The first connection conductor electrically connects the first electrode and the first signal line to each other inside the insulating substrate.

The second connection conductor is located between the first signal line and the second signal line inside the insulating substrate.

The ground conductor includes a first ground plane, an inside-first-groove ground plane, a second ground plane, and a ground connection conductor.

The first ground plane is located on the first surface.

The inside-first-groove ground plane is located at a bottom of the first groove.

The second ground plane is located inside the insulating substrate with the first signal line interposed between the second ground plane and the first surface.

The ground connection conductor is located along the second connection conductor inside the insulating substrate.

Part of the ground connection conductor is located around the second connection conductor and forms a coaxial structure together with the second connection conductor.

The first signal line forms a stripline structure in a region where the first signal line faces the first ground plane and the second ground plane.

In planar perspective view of the first surface, a position on the first surface including an end portion of the second connection conductor on an opposite side from a point of contact with the second signal line is located in a gap region that does not contain the first ground plane.

### BRIEF DESCRIPTION OF THE DRAWINGS

FIG. 1 is an overall perspective view of a semiconductor electronic device of an embodiment with the top cover removed.
FIG. 2 is a bottom view illustrating a first surface of the semiconductor electronic device.
FIG. 3A is a diagram illustrating in detail part of the first surface in an enlarged manner.
FIG. 3B is a bottom view illustrating in detail part of the first surface in an enlarged manner.
FIG. 4 illustrates a cross section including one signal electrode of a wiring substrate.
FIG. 5A is a slice cross section of the wiring substrate.
FIG. 5B is a slice cross section of the wiring substrate.
FIG. 6 is a graph illustrating simulation results relating to the dependence of signal insertion loss on frequency for the wiring substrate of the embodiment.
FIG. 7A is a drawing for describing a semiconductor package of Modification 1.
FIG. 7B is a drawing for describing the semiconductor package of Modification 1.
FIG. 8 illustrates a cross section including one signal electrode of a wiring substrate of Modification 2.
FIG. 9 is a drawing for describing the positions of differential lines in the wiring substrate of Modification 2.

### DESCRIPTION OF EMBODIMENTS

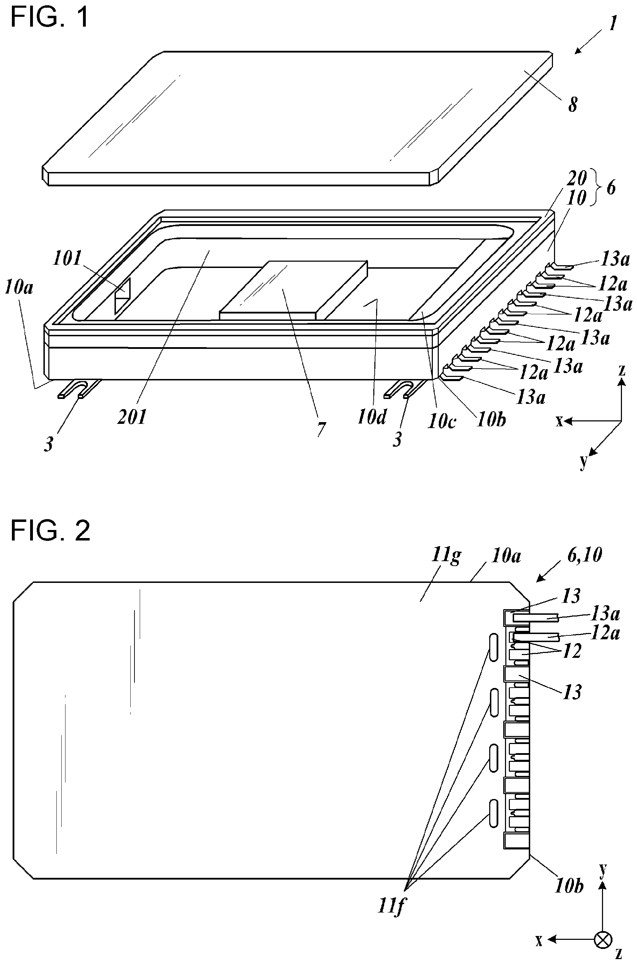

Hereafter, an embodiment will be described based on the drawings. FIG. 1 is an overall perspective view of a semiconductor electronic device 1 of this embodiment with the top cover removed.
The semiconductor electronic device 1 includes a semiconductor package 6, an electronic component 7, and a lid 8.

The semiconductor package 6 includes a wiring substrate 10 and a frame 20. The semiconductor package 6 may also include fasteners 3 that are used to fasten the package to a substrate or another member.

The wiring substrate 10 and the frame 20 overlap each other in a vertical direction (in a z direction) and are bonded to each other. The wiring substrate 10 has a substantially rectangular shape in plan view looking in the z direction (the corners may be rounded or cut off), but is not limited to this shape. A bottom surface (first surface 10a) of the wiring substrate 10 is flat. Atop surface of the wiring substrate 10 includes a flat portion (third surface 10d) in the center that is one step lower and a flat portion (second surface 10c) that is positioned around the periphery of the third surface 10d and is higher than the third surface 10d.

The frame 20 has an annular shape that surrounds the outer edge of the wiring substrate 10 in plan view. The frame 20 is bonded to the second surface 10c. The second surface 10c includes a portion that is wider than the width of the frame 20 and has a step-like shape. The top surface of the frame 20 has a uniform height. The semiconductor package 6 is shaped such that the third surface 10d of the wiring substrate 10 serves as a bottom surface and the bottom surface is surrounded on four sides by surrounding protruding portions constituting the second surface 10c and the frame 20, and has a recess 201 that opens in the upward direction.

The wiring substrate 10 or the frame 20 may have an opening 101 in one surface that forms a side surface of the semiconductor package 6. For example, light would be able to pass through this opening 101 when the electronic component 7 includes an optical component such as a photodiode or a laser diode. The inside and outside of the semiconductor package 6 may be partitioned from each other by a light-transmitting material such as glass or transparent resin in the opening 101.

The lid 8 is bonded to the top surface of the frame 20 and covers the top of the recess 201. The frame 20 and lid 8 are both composed of conductors, and for example, may be composed of a metal such as iron, copper, nickel, chromium, cobalt, molybdenum or tungsten, or an alloy of any of these metals. The materials of the frame 20 and the lid 8 may be the same as each other but do not need to be the same as each other.

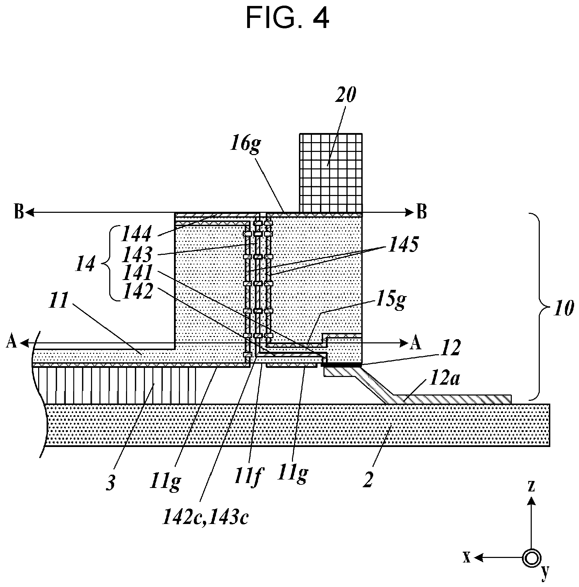

The wiring substrate 10 includes an insulating substrate 11 (refer to FIG. 4), a ground conductor, and signal lines. Signal lines extend along the surface of and through the inside of the insulating substrate 11 and electrically connect terminals located on the second surface 10c to leads 12a (lead terminals) positioned so as to project outward from an edge 10b, which is one edge of the first surface 10a. The ground conductor is electrically connected to leads 13a.

The electronic component 7 is positioned on the third surface 10d and fits inside the recess 201. The terminals of the electronic component 7 and terminals on the second surface 10c are connected to each other by bonding wires or the like (not illustrated) so as to allow transmission and reception of signals.

FIG. 2 is a bottom view illustrating the first surface 10a of the semiconductor package 6 (wiring substrate 10). Multiple signal electrodes 12 (first electrodes) and ground electrodes 13 (second electrodes) and so on are disposed in a line with some degree of spacing therebetween along the edge 10b (one edge of the first surface 10a), which is an end portion of the bottom surface of wiring substrate 10 in the -x direction. Each signal electrode 12 includes a lead 12a (conductor connection portion) and each ground electrode 13 includes a lead 13a (only one each of the leads 12a and 13a is illustrated here). The remaining part of the first surface 10a is not particularly limited, and is mostly made up of a ground plane 11g (first ground plane), except for around the signal electrodes 12 and in gap regions 11f.

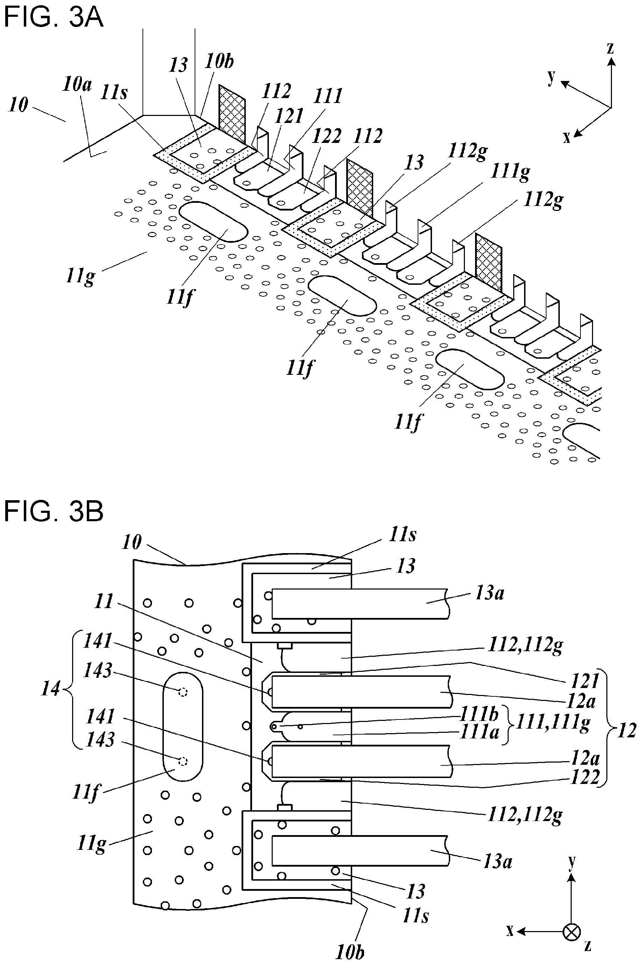

FIGs. 3A and 3B illustrate enlarged detailed views of part of the first surface 10a. FIG. 3A is a perspective view and FIG. 3B is a bottom view. For illustration purposes, the leads 12a and 13a are omitted from FIG. 3A. Each set of signal electrodes 12 includes two (one pair of) signal electrodes 121 and 122 arrayed in the y direction, and these electrodes transmit differential signals as a pair. The ground electrodes 13 are positioned on both sides of a pair of signal electrodes 121 and 122 in the y direction. A coating film 11s is disposed on the surface around the ground electrodes 13. The coating film 11s is, for example, a thin alumina film. The ground electrodes 13 and the surrounding ground plane 11g are connected to each other under the coating film 11s.

One end of each of the signal electrodes 12 and one end of each of the ground electrodes 13, for example, contact the edge 10b. These signal electrodes 12 and ground electrodes 13 extend in a direction perpendicular to the edge 10b (x direction). The leads 12a extend along the direction of extension (in the x direction) of the exposed surfaces of the signal electrodes 12 on the first surface 10a and are bonded to the exposed surfaces. The leads 13a extend along the direction of extension (in the x direction) of the exposed surfaces of the ground electrodes 13 on the first surface 10a and are bonded to the exposed surfaces. The remaining portions of the leads 12a and 13a that are not bonded to the exposed surfaces are bent and led to outside the wiring substrate 10 in plan view. The signal electrodes 12 have, for example, a width of 0.5 to 2 mm in the y direction and a length of 1 to 20 mm in the x direction. The ground electrodes 13 may have a different size (here slightly larger) or have the same size as the signal electrodes 12.

Differential lines 14, which are a pair of signal lines configured to carry differential signals, each include a first via-hole conductor 141 and a second via-hole conductor 143, as described below in detail. The first via-hole conductor 141 extends directly from the first surface 10a into the inside of the insulating substrate 11 (in the +z direction) at a position so as to at least partially overlap, in this case around half, the corresponding lead 12a in plan view. The differential lines 14 are bent inside the wiring substrate 10 and are connected to the second via-hole conductors 143, which are positioned so as to not overlap the frame 20, as described below. Each gap region 11f is positioned within a region that overlaps (includes both) the second via-hole conductors 143 of the corresponding pair of differential lines 14 in planar perspective view of the inside of the insulating substrate 11 in the z direction, and has, for example, an ellipsoidal shape (a shape obtained by combining two semicircles and a rectangle connected between the semicircles. Also called a rounded rectangle). In other words, each pair of second via-hole conductors 143 commonly overlap a corresponding single gap region 11f in plan view.

In FIG. 3A, three pairs of differential lines 14 are illustrated, and the ground electrodes 13 may be shared by adjacent differential lines 14. The number of pairs of differential lines 14 may be determined as appropriate in accordance with the number of signals that need to be transmitted. In this FIG. 3A, reference symbols are provided for the components of only one of the pairs, but the other pairs whose reference symbols are omitted are identical.

A first groove 111 is positioned in the first surface 10a of the wiring substrate 10 (insulating substrate 11) between each pair of signal electrodes 121 and 122. The first groove 111 extends along the signal electrodes 12, for example, from the edge 10b in a direction perpendicular to the edge 10b (in the x direction) with a certain depth (distance from the first surface 10a. For example, 0.5 to 5 mm).

A second groove 112 is positioned between each signal electrode 12 and the corresponding ground electrode 13 adjacent to that signal electrode 12. Each second groove 112 extends along the corresponding signal electrode 12, for example, from the edge 10b in a direction perpendicular (x direction) to the edge 10b. The depth of the second grooves 112 may be the same as (for example, 0.5 to 5 mm) or different (for example, shallower) than the depth of the first grooves 111. If the second grooves 112 are shallower than the first grooves 111, arranging the differential lines 14 extending from the signal electrodes 12 inside the wiring substrate 10 (insulating substrate 11) would be relatively easier.

The shape of each first groove 111 and second groove 112 is, for example, a substantially rectangular shape having a width (length in the y direction) of 0.2 to 2 mm and a length (length in the x direction) slightly shorter than the length (1 to 20 mm) of the signal electrodes 12 in plan view (bottom view). The shape of the first and second grooves 111 and 112 is rounded (For example, the radius of curvature of the second groove 112 is about 0.1 to 1 mm. The shape of the tip of the first groove 111 is described below.) and becomes thinner in the vicinity of positions furthest from edge 10b (tip). The first grooves 111 may be longer than the second grooves 112. The shape with respect to the depth direction is rectangular in lateral view in the x direction, and the bottom is flat. The shapes of the first and second grooves 111 and 112 may be different from the shapes described above. For example, the first grooves 111 and/or second grooves 112 may have a tapered shape, a reverse tapered shape, or staircase shape consisting of multiple steps in lateral view.

As illustrated in FIG. 3B, each first groove 111 is divided into a base portion 111a and a projecting portion 111b. The base portion 111a includes a semicircular rounded portion having a radius of curvature of about 0.1 to 1 mm, similar to the second groove 112, at the tip (end spaced away from edge 10b) of a long rectangular shape. The projecting portion 111b is positioned so as to be connected to the semicircular tip of the first groove 111 (other end of base portion 111a on opposite side from edge 10b). For example, a center position of the semicircular tip of the base portion 111a and a center position of the semicircular portion of the projecting portion 111b in the y direction are identical to each other. The projecting portion 111b is narrower in the Y direction along the edge 10b than the base portion 111a (for example, 0.2 mm wide). The projecting portion 111b is shaped so as to become narrower towards the tip (larger x component). The shape of the projecting portion 111b is, for example, semi-cylindrical (semi-circular in plan view) with a radius of 0.05 mm, and this enables better dispersion of stress than a rectangular shape, but the projecting portion 111b is not limited to this shape.

Thus, the wiring substrate 10 is structured so as to allow the length of the first grooves 111 to be made as long as possible while increasing the distance from the first grooves 111 to the positions of the first via-hole conductors 141. If the first via-hole conductors 141 and the first and second grooves 111 and 112 are too close together, fractures (cracks) are more likely to occur during their formation, and therefore the first and second grooves 111 and 112 need to be at least a prescribed distance away from the first via-hole conductors 141 (in order to provide clearance). On the other hand, if the first and second grooves 111 and 112 are made shorter, problems such as the characteristic impedance of the differential lines 14 being reduced are more likely to occur.

A ground conductor 111g (inside-first-groove ground plane) and a ground conductor 112g (inside-second-groove ground plane) are respectively located at the bottoms of each first groove 111 and each second groove 112 (plane parallel to first surface 10a, located on +z side with respect to first surface 10a). By having a wider ground plane in addition to the ground plane 11g for the signal electrodes 121, crosstalk between the signal electrodes 12 can be reduced and the radio-frequency signal characteristics can be improved.

The projecting portion 111b may have the same depth as the base portion 111a (for example, 0.5 to 5 mm) or may be shallower than the base portion 111a. The ground conductor 111g inside the first groove 111 may extend to the bottom of the projecting portion 111b. These depths may be determined by taking the length of the first via-hole conductor 141, i.e., the distance of a first signal line 142 from the ground plane 11g into consideration. If the material (dielectric constant) of the insulating substrate 11 varies from place to place, for example, the characteristic impedance may be adjusted by varying the depth between the base portion 111a and the projecting portion 111b.

The tip of the ground conductor 111g in the first groove 111 (projecting portion 11 1b) is positioned closer to the edge 10b than the tip of the signal electrode 12 is in plan view. Here, the ground conductor 111g does not extend to a position further from the edge 10b than the position of the first via-hole conductor 141 is in plan view.

An inner wall surface (side surface) of the projecting portion 111b may also have a ground plane, and this ground plane may electrically connect the ground plane 11g and a ground plane 15g to each other instead of through vias.

As in this embodiment, the first groove 111 and the ground conductor 111g are shaped so as to be symmetrical about a centerline between the two signal electrodes 121 and 122 in the y direction, and as a result the differences in the effects of the first groove 111 and ground conductor 111g on the signal electrodes 121 and 122 can be reduced. This allows variations in signal transmission characteristics, such as variations in transmission speed (propagation delay) and differences in the magnitude of signal loss to be reduced.

The dielectric constant between the signal electrodes 12 can be made lower than if the signal electrodes 12 were simply aligned on a surface of the insulating substrate 11 by using a structure that includes a region having a lower dielectric constant than the insulating substrate 11 between a pair of signal electrodes 121 and 122. As a result, a reduction in the characteristic impedance is suppressed even when the spacing between the signal electrodes 121 and 122 is small. The depth of the first and/or second grooves 111 and/or 112, i.e., the distance from the first surface 10a, may be the same as the distance from the first surface 10a to the ground plane 15g (refer to FIG. 4) described below, which is located inside the insulating substrate 11. In this case, the ground plane 15g may be extended also to the ground conductors 111g and 112g at the bottoms of the first and second grooves 111 and 112. The first and second grooves 111 and 112 may be filled with another insulating material having a lower dielectric constant than the insulating substrate 11.

The ground plane 11g and the ground electrode 13 are electrically connected to other ground planes inside the wiring substrate 10 by a number of ground via-hole conductors (black circles in the figure).

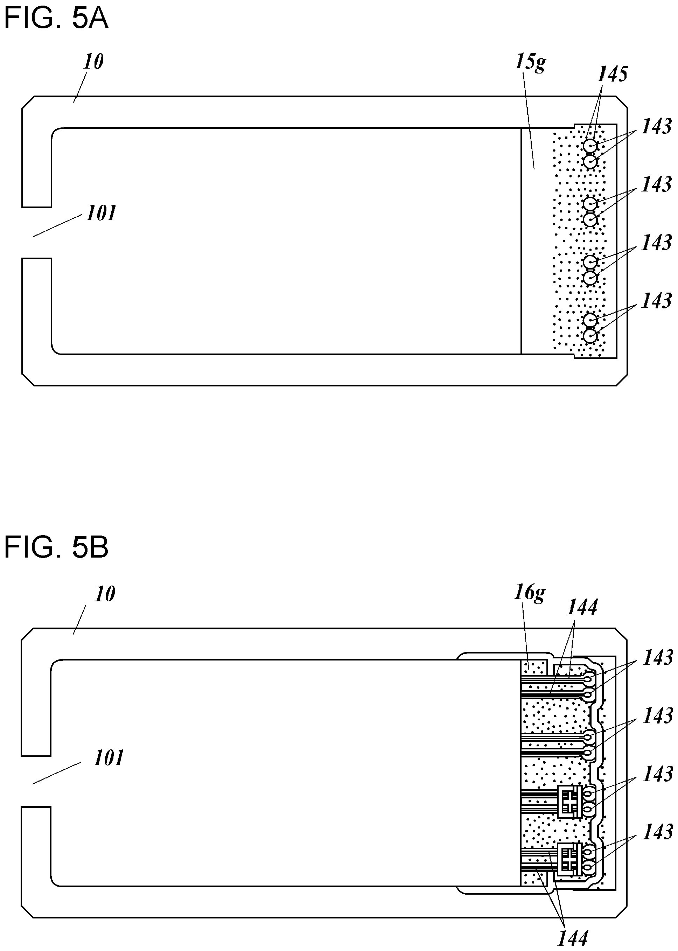

FIG. 4 illustrates a cross section of the wiring substrate 10 taken along the xz plane including one signal electrode 121 and a differential line 14. FIG. 5A is a slice cross-sectional view taken along a cross-sectional line AA in FIG. 4, and FIG. 5B is a slice cross-sectional view taken along a cross-sectional line BB in FIG. 4. The structure of a cross section including the signal electrode 122 is basically the same as the structure of a cross section including the signal electrode 121, and description thereof is omitted.

As described above, the differential line 14 inside the wiring substrate 10 is connected to the signal electrode 121. Each signal line of the differential lines 14 includes a first via-hole conductor 141 (first connection conductor), a first signal line 142, a second via-hole conductor 143 (second connection conductor), and a second signal line 144. The first signal line 142 extends parallel to the first surface 10a along the bottom surface (first surface 10a) of the wiring substrate 10 inside the insulating substrate 11. The second signal line 144 is positioned on the top surface (second surface 10c) of the wiring substrate 10. The first via-hole conductor 141 extends perpendicular to the first surface 10a and electrically connects the signal electrode 121 to the first signal line 142. The second via-hole conductor 143 is positioned between the first signal line 142 and the second signal line 144 in the differential line 14. The second via-hole conductor 143 extends perpendicular to the first surface 10a. Here, one end portion of the second via-hole conductor 143 (a second end portion 143c on opposite side from point of contact with second signal line 144) is directly connected to one end portion (first end portion 142c on opposite side from point of contact with first via-hole conductor 141) of the first signal line 142, and thus the second via-hole conductor 143 electrically connects the first signal line 142 to the second signal line 144.

The insulating substrate 11 includes the ground plane 15g (second ground plane) parallel to the ground plane 11g of the first surface 10a inside the insulating substrate 11. The ground plane 11g and the ground plane 15g are electrically connected to each other by multiple ground via-hole conductors, which are illustrated as black circles in FIG. 2, FIG. 3A, FIG. 3B, and so on.

Wiring lines such as the signal electrodes 12, the ground electrodes 13, the ground planes 11g and 15g, and the differential lines 14 are, for example, metal layers containing a metallic material such as gold, silver, copper, nickel, tungsten, molybdenum or manganese, or a combination of any of these metals. A nickel or gold plating layer may be additionally stacked on the surface of such a metal layer. This plating layer improves corrosion and weather resistance, and also improves the wettability of bonding materials such as brazing and soldering materials used for bonding to a metal layer.

The first via-hole conductor 141 overlaps the position of the frame 20 in plan view, as described above. Therefore, if the first via-hole conductor 141 simply penetrates through the insulating substrate 11, the first via-hole conductor 141 would be in close proximity to the frame 20 and adjusting the characteristic impedance would be difficult. Therefore, the first via-hole conductor 141 is connected to the second via-hole conductor 143, which does not overlap the position of the frame 20 in plan view, via the first signal line 142.

The first signal line 142 is positioned between the ground plane 11g and the ground plane 15g. As a result, the first signal line 142 forms a stripline structure together with the ground plane 11g and the ground plane 15g in the area where the first signal line 142 is interposed between the ground plane 11g and the ground plane 15g (faces the ground planes 11g and 15g). The distance of the first signal line 142 from the ground plane 11g and the distance of the first signal line 142 from the ground plane 15g are determined in accordance with the characteristic impedance for the stripline structure.

There are multiple ground via-hole conductors 145 (ground connection conductors) positioned parallel to the second via-hole conductor 143 between the ground planes 11g and 15g and a ground plane 16g of the second surface 10c. In the drawing of the inside of this cross section, one ground via-hole conductor 145 is illustrated on both sides, and as illustrated in FIG. 5A, part of the ground via-hole conductor 145 is positioned around the second via-hole conductor 143 at a prescribed distance. The second via-hole conductor 143 and the ground via-hole conductor 145 in this positional relationship form a coaxial structure. The prescribed distance between the second via-hole conductor 143 and the surrounding ground via-hole conductor 145 is determined in accordance with the characteristic impedance for the coaxial structure. There are other ground planes inside the insulating substrate 11, such as between the ground planes 15g and 16g, and the ground via-hole conductors 145 may be electrically connected to these ground planes.

As illustrated in FIG. 5B, the second signal lines 144 extend to an end portion of the second surface 10c facing the recess 201 and are electrically connected to the electronic component 7 by bonding wires or other means, as described above.

Thus, a pair of differential lines 14 are led directly from the corresponding signal electrodes 12 to the inside of the wiring substrate 10 (insulating substrate 11) and does not include any signal lines that extend to the first surface 10a. Thus, losses from signal lines, which occur more frequently with radio-frequency signals, especially those at several tens of GHz or higher, can be reduced in this wiring substrate 10.

The pair of differential lines 14 undergoes a mode change between a coaxial structure and a stripline structure inside the wiring substrate 10. In order to reduce changes in characteristic impedance that occur at the bent part relating to the mode change, this wiring substrate 10 includes the gap region 11f, where there is no ground plane 11g and the insulating substrate 11 is exposed (there may be a protective film or the like), at the position of the bend in planar perspective view in a direction perpendicular to the first surface 10a (Z direction), that is, at a position including the point of contact between the first signal line 142 and the second via-hole conductor 143.

The gap region 11f is shared by the pair of second via-hole conductors 143 of the pair of differential lines 14, as illustrated in FIG. 2 and so on. The outer periphery of the gap region 11f is not particularly restricted, but may be defined so as to extend along the inner edges of the multiple ground via-hole conductors that form a coaxial structure. As a result, loss caused by radio-frequency signals being radiated from this gap region can be reduced while suppressing fluctuations in the characteristic impedance.

As illustrated in FIG. 3A and FIG. 3B, the first via-hole conductors 141 are positioned so as to at least partially overlap the leads 12a in plan view. This allows radio-frequency signals to pass between the leads 12a and inner layers of the insulating substrate 11 directly below the leads 12a without signal lines being arranged on the first surface 10a, and therefore radiation of radio-frequency signals from the first surface 10a can be suppressed.

The leads 12a (leads 13a) are connected to an external substrate 2, for example, a printed circuit board (PCB). The fasteners 3 fix and support the semiconductor package 6 on the substrate 2.

In manufacture of the wiring substrate 10, the insulating substrate 11 may be fabricated by stacking multiple insulating sheets (ceramic green sheets), which are formed into sheets from a slurry prepared by mixing organic binders and solvents with powders of material substances (for example, aluminum oxide and silicon oxide), and then subjecting the sheets to pressure bonding and sintering (for example, performing heating at about 1600°C in a reducing atmosphere). The fired substrate is subjecting to processing such as cutting, punching, and so on as appropriate. In fabrication of the ground plane 15g and the first signal lines 142 and so on inside the insulating substrate 11, for example, a metal paste is first prepared by mixing the conductor metal, binder and organic solvent described above. Next, this metal paste is applied by screen printing or another method to an insulating sheet that will be at either the top or the bottom when the insulating sheets are stacked. This insulating sheet is then stacked together with the ordinary insulating sheets as described above, and then press bonded and fired.

The first via-hole conductors 141, the second via-hole conductors 143, and the ground via-hole conductors 145 may be obtained, for example, by forming through holes during or after stacking the insulating sheets, filling the holes with the metal paste, and then performing firing. Through holes are formed, for example, by performing punching using metal pins or by laser processing. For filling the metal paste, vacuum suction, for example, may be used or may be used in combination with another method.

The first and second grooves 111 and 112 may be formed by forming notches in the relevant portions from the formed insulating substrate 11.

The ground planes 11g and 16g, the signal electrodes 12, the ground electrodes 13, and the second signal lines 144 and so on positioned on the exposed surfaces (surfaces) of the insulating substrate 11 may be obtained by firing metallized layers on the surface of the insulating substrate 11 or may be formed by plating. A nickel or gold plating layer may be additionally stacked on the surface of such a metal layer.

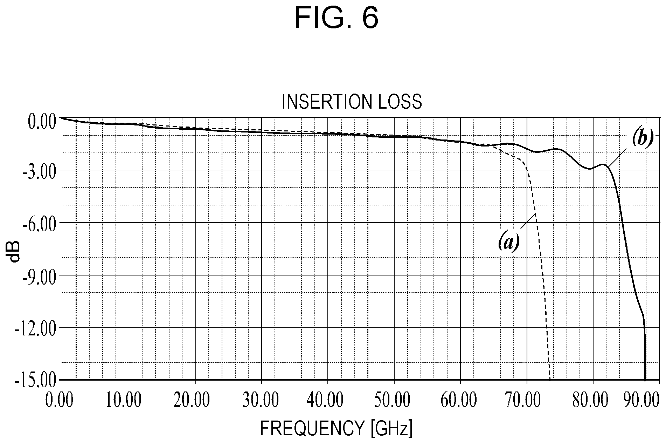

FIG. 6 is a graph depicting simulation results illustrating (b) signal insertion loss with respect to frequency for the wiring substrate 10 of this embodiment compared to the (a) signal insertion loss for a wiring substrate of the related art. The measurement range of insertion loss is from the tip of the lead 12a to the end portion of the second signal line 144. The higher the value, i.e., the closer to 0 [dB], the smaller the insertion loss.

In the wiring substrate of the related art, the second via-hole conductor 143 penetrates directly between the first surface 10a and the second surface 10c, and a signal line that electrically connects the second via-hole conductor 143 and the signal electrode 12 to each other is positioned on the surface of the first surface 10a. According to the obtained results, the insertion loss of radio-frequency signals, particularly those in the 60 to 80 GHz band, was reduced compared to this wiring substrate of the related art.

### [Modifications]

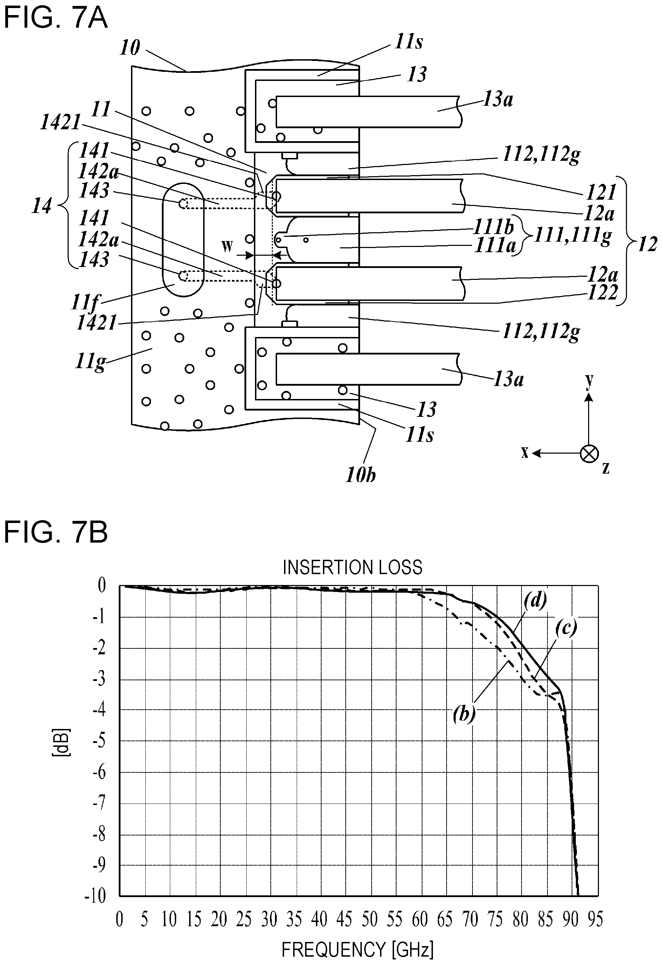

FIG. 7A and FIG. 7B are diagrams for describing Modification 1 of the semiconductor package 6.

As mentioned above, gaps are needed between the signal electrodes 121 and 122 and the ground plane 11g around the peripheries of the signal electrodes 121 and 122. In the bottom view in FIG. 7A, a first signal line 142a does not overlap the ground plane 11g in planar perspective view across a width w from the position of the first via-hole conductor 141.

In order to compensate for the insufficient capacitance of the first signal line 142a in this region, in the semiconductor package 6 of Modification 1, the first signal line 142a has a wide portion 1421 between a connection portion with the first via-hole conductor 141 and the region where the first signal line 142a does not overlap the ground plane 11g (different from the gap region 11f) in planar perspective view. The wide portion 1421 may span the entire width w including the parts overlapping the signal electrodes 121 and 122 in planar perspective view. Increasing the width of the first signal line 142a adds electrical capacitance in this area and reduces the characteristic impedance. The width of the wide portion 1421 may be determined in accordance with the characteristic impedance.

The first signal line 142a may include a wide portion 1421 configured in such a way as to not reduce the spacing between the pair of differential lines 14. In other words, the first signal line 142a extends towards the opposite side from the first groove 111 with respect to the Y direction in planar perspective view. An increased effect on signals between a pair of first signal lines 142a can be reduced by not making the distance between the first signal lines 142a smaller than necessary.

In the above embodiment, the first via-hole conductor 141 and the second via-hole conductor 143 are assumed to be at the same position with respect to the Y direction, but may instead be at different positions with respect to the Y direction depending on the spacing (pitch) of the leads 12a. In this case, the width between the differential lines 14 (first signal lines 142a) may also be adjusted in this portion of the width w.

FIG. 7B illustrates the results of a simulation in which the partial insertion loss between the lead 12a and the second via-hole conductor 143 was calculated for the wide portion 1421.

Compared to a case (b) in which the wide portion 1421 is not provided as in the above embodiment, the insertion loss is smaller in a radio-frequency band of 60 GHz and above even in a case (c) of partial widening in which the wide portion 1421 is not provided in areas overlapping the signal electrodes 121 and 122. Furthermore, in a case (d) in which the wide portion 1421 is provided across the entire width w, including the areas overlapping the signal electrodes 121 and 122, the insertion loss is more markedly reduced in a radio-frequency band.

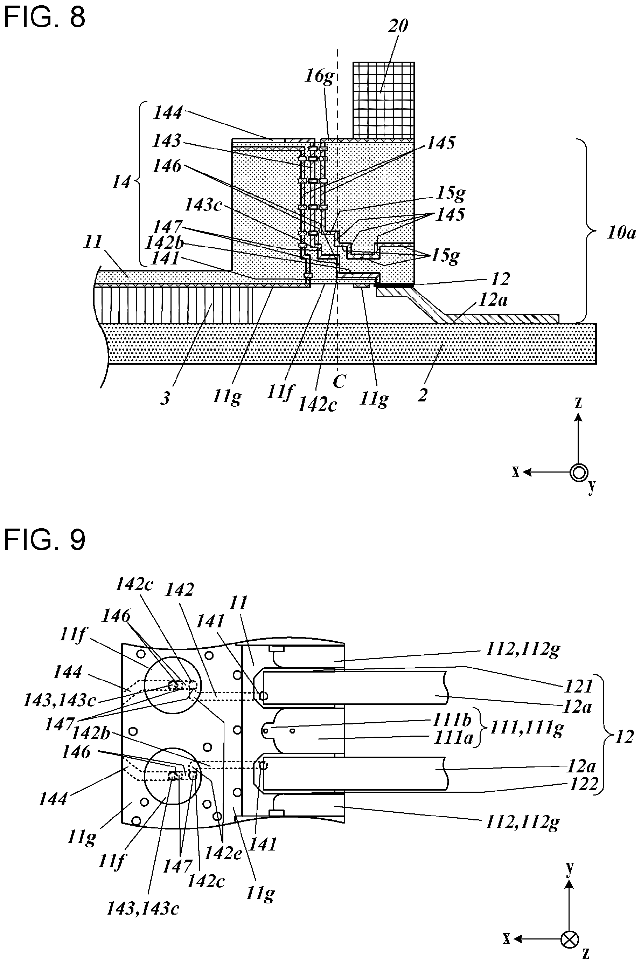

FIG. 8 illustrates a cross section taken along an xz plane including one signal electrode 121 and one differential line 14 of the wiring substrate 10 in Modification 2 of the semiconductor package 6. As described below, the differential line 14 includes a portion that is bent in the y direction in this Modification 2, and therefore the position of the cross section (position in the y direction) is different on the left and right sides of a dashed line C.

Here, the differential line 14 is bent at multiple points along a curve, for example, a hyperbola, between a first signal line 142b and the second via-hole conductor 143, and a third signal line 146 and a third via-hole conductor 147 (third connection conductor) are disposed in an alternating manner. In other words, multiple pairs of the third via-hole conductor 147 and the third signal line 146, which are connected to each other at ends thereof, are connected in series between the first signal line 142b and the second via-hole conductor 143.

If the differential lines 14 can be given a curved shape, the reflection loss can be significantly reduced, but since disposing multiple curved wiring lines so as to have an appropriate positional relationship inside the insulating substrate 11 is difficult, small bends on a scale shorter than the signal length are used in the wiring substrate 10 in order to approximate curved shapes, and in this way, the reflection loss is reduced. Thus, in the differential line 14, the ratio of the length of the third via-hole conductor 147 to the length of the third signal line 146 in each pair is greater than the ratio of the length of the first via-hole conductor 141 to the first signal line 142b, and this ratio becomes larger, the closer each pair is to the second end portion 143c.

The positions of the ground planes 15g are also divided into different positions with respect to the z direction in accordance with the positions of the first signal line 142b and the multiple third signal lines 146 inside the insulating substrate 11, and multiple ground planes 15g are connected to each other by ground via-hole conductors 145.

The gap regions 11f in Modification 2 are independently provided for each of the differential lines 14. Each gap region 11f may encompass at least the second via-hole conductor 143 of the corresponding differential line 14 in planar perspective view, and may also encompass part of or all of the third via-hole conductor 147.

FIG. 9 illustrates the positions of the differential lines 14 as seen from the below the wiring substrate 10 of Modification 2 illustrated in FIG. 8.

Each first signal line 142b, which extends parallel to the ground plane 15g inside the insulating substrate 11, has a bend 142e between the corresponding first via-hole conductor 141 and second via-hole conductor 143. The coupling between signals can be strengthened by reducing the distance between the differential lines 14, but on the other hand, there is a limit on the minimum distance between the second via-hole conductors 143. The bends 142e are located near the boundaries of the gap regions 11f in planar perspective view and are shaped such that the distance between parts of the differential lines 14 is smaller outside the gap regions 11f. The specific distance is defined so that the appropriate characteristic impedance is obtained. In addition to the coaxial lines relating to the second via-hole conductors 143 and the stripline lines relating to the first signal lines 142b as described above, the third signal lines 146 become grounded coplanar lines in the gap region 11f with respect to the ground plane located in the surrounding area in the xy direction. The appropriate interline distance for differential lines that are coaxial lines is wider than the appropriate interline distance for differential lines of other types of lines, and is therefore adjusted to the appropriate distance forwards and backward by using the above bends 142e. Improved coupling between differential signals results in improved signal characteristics in a radio-frequency band.

As described above, the semiconductor package 6 of this embodiment includes the insulating substrate 11 having the first surface 10a and the second surface 10c on the opposite side from the first surface 10a, a pair of signal electrodes 12 disposed side by side along one edge of the first surface 10a, a pair of differential lines 14 respectively electrically connected to the pair of signal electrodes 12 and configured to carry signals, and the ground conductor. The insulating substrate 11 includes the first groove 111 located on the first surface 10a and extending between the pair of signal electrodes 12. Each of the pair of differential lines 14 includes the first signal line 142 located inside the insulating substrate 11 and extending along the first surface 10a, the second signal line 144 located on the second surface 10c, the first via hole conductor 141 electrically connecting the signal electrode 12 and the first signal line 142 to each other inside the insulating substrate 11, and the second via-hole conductor 143 located between the first signal line 142 and the second signal line 144 inside the insulating substrate 11. The ground conductor includes the ground plane 11g located on the first surface 10a, the ground conductor 111g located at the bottom of the first groove 111, the ground plane 15g located inside the insulating substrate 11 with the first signal line 142 interposed between the ground plane 15g and the first surface 10a, and the ground via-hole conductor 145 located along the second via-hole conductor inside the insulating substrate 11. Part of the ground via-hole conductor 145 is located around the second via-hole conductor 143 and forms a coaxial structure together with the second via-hole conductor. The first signal line 142 forms a stripline structure together with the ground planes 11g and 15g in the region where the first signal line 142 faces the ground planes 11g and 15g. The position of the second end portion 143c of the second via-hole conductor 143 in planar perspective view of the first surface 10a is located in the gap region 11f, which does not contain the ground plane 11g.
Thus, each differential line 14 proceeds directly from the corresponding signal electrode 121 to the insulating substrate 11, and as a result, signal loss is reduced by due to radio-frequency signals radiated from the plane of the first surface 10a being suppressed. The differential line 14 undergoes a mode change between a stripline structure and a coaxial structure inside the insulating substrate 11. The ground plane 11g on the first surface 10a is structured so as to include the gap region 11f corresponding to this switching area, and this enables adverse effects on the characteristic impedance to be suppressed. Thus, signal loss can be reduced more effectively while maintaining an appropriate characteristic impedance even for signals of a higher frequency band than was previously possible. Therefore, this semiconductor package 6 can transmit higher frequency signals.

In plan view of the first surface 10a, the furthest position of the ground conductor 111g from the edge 10b is closer to the edge 10b than the furthest position of the signal electrode 12 from the edge 10b. This allows the ground conductor 111G to be defined within a range so that here is no effect on signal transmission.

The first groove 111 includes the base portion 111a and the projecting portion 111b. The projecting portion 111b is positioned so as to be connected to an end of the base portion 111a on the opposite side from the edge 10b and is narrower than the base portion 111a in the y direction perpendicular to the x direction in which the first groove 111 extends. This allows the surface area (volume) of the first groove 111 to be increased while maintaining a prescribed distance between the first groove 111 and the first via-hole conductor 141, and therefore the occurrence of cracks and other defects during the formation of the first groove 111 and first via-hole conductor 141 can be reduced, the distance between the signal electrodes 121 and 122 can be reduced due to the decrease in dielectric constant corresponding to the first groove 111, and the semiconductor package 6 can be reduced in size.

The first end portion 142c of the first signal line 142, which on the opposite side to the point of contact with the first via-hole conductor 141, and the second end portion 143c of the second via-hole conductor 143, which is on the opposite side from the point of contact with the second signal line 144, may be directly connected to each other. Such a structure can be easily formed without a large increase in labor and can realize a reduction in signal loss.

As in Modification 1, the first signal line 142a may include the wide portion 1421. In the wide portion 1421, the line width of part of the first signal line 142a is wider, in the Y direction perpendicular to the extension direction (X direction) of the first signal line 142a, in a region of the width w that does not overlap the ground plane 11g and is different from the gap region 11f in planar perspective view of the first surface 10a. Since a gap is required between the signal electrode 12 and the ground plane 11g, the ground plane corresponding to the first signal line 142a is insufficient on the side where the first via-hole conductor 141 and the first signal line 142a are connected to each other. In contrast, in the semiconductor package 6, since the line width of the first signal line 142a is partially widened in this area, the capacitance of the signal line is increased in this area, the characteristic impedance is more appropriately defined, and signals can be stably transmitted with less loss than was previously possible.

The wide portion 1421 may extend over the entire area between the position where the first signal line 142a is connected to the first via-hole conductor 141 and the boundary of the region where the first signal line 142a overlaps the ground plane 11g in planar perspective view of the first surface.

The wide portion 1421 may have an increased width on the opposite side from the first groove 111 in planar perspective view of the first surface 10a. In other words, since the distance between two first signal lines 142A positioned adjacent to each other is not reduced, signal degradation due to the first signal lines 142A affecting each other can be suppressed.

In Modification 2, the first end portion 142c of the first signal line 142b is positioned closer to the first surface 10a and closer to the first via-hole conductor 141 in planar perspective view of the first surface 10a than the second end portion 143c of the second via-hole conductor 143 is, and the first end portion 142c and the second end portion 143c are connected to each other by the third via-hole conductor 147 parallel to the via-hole conductor 141 and the third signal line 146 parallel to the first signal line 142. By changing the direction of the differential line 14 in a gradual staircase-like pattern, rather than being bent in one go, losses due to sudden changes in signal direction can be reduced.

In particular, multiple pairs of the third via-hole conductor 147 and the third signal line 146, which are connected to each other at ends thereof, are connected in series between the first and second end portions 142c and 143c, and the ratio of the length of the third via-hole conductor 147 to the length of the third signal line 146 is greater than the ratio of the length of the first via-hole conductor 141 to the length of the first signal line 142b, and this ratio becomes larger, the closer each pair is to the second end portion 143c. Thus, signal loss can be further reduced by changing the average slope of the differential line so that the differential line gradually points in the vertical direction (z direction) from the first signal line 142b to the second via-hole conductor 143.

The spacing of the first signal lines 142b in the differential lines 14 is larger than the spacing of the second via-hole conductors 143. In other words, the spacing of each pair of differential lines 14 may be changed midway along the differential lines 14 so that the spacing of the differential lines 14 is appropriately defined for the stripline structure and the coaxial line structure. Even if the spacing cannot be reduced due to the structure of the via holes, coupling between the signals can be increased by partially reducing the spacing of the differential lines 14 in the stripline section so as to improve the characteristics in a radio-frequency range.

The position of each third via-hole conductor 147 in planar perspective view may be contained in the gap region 11f. In this case, each third signal line 146 can be structured like a grounded coplanar line, and this enables the characteristics between the first signal line 142b and the second via-hole conductor 143 to be easily adjusted as appropriate.

The gap region 11f for each of the pair of differential lines 14 consists of a single connected region. This enables better transmission of radio-frequency signals by reducing variations in the characteristic impedance of differential signals.

Alternatively, the gap regions 11f may be separated from each other for each of the second via-hole conductors 143 of the differential lines 14. Even in this case, radio-frequency signals can be transmitted better than was previously possible by appropriately designing each path.

The outer edge of the gap regions 11f overlap, in semicircular shapes, the inner edges of the ground via-hole conductors 145, which form coaxial structures with the pair of second via-hole conductors 143, in planar perspective view of the first surface 10a. This enables better transmission of radio-frequency signals than was previously possible by reducing the radiation of radio-frequency signals from the gap regions 11f while reducing the effects of fluctuations in the characteristic impedance for signal transmission in the coaxial structures.

The semiconductor package 6 further includes a pair of ground electrodes 13 that are positioned on opposite sides of the pair of signal electrodes 12 from the first groove 111 with respect to the y direction along the edge 10b and are electrically connected to the ground plane 11g. The insulating substrate 11 includes the second grooves 112 positioned between the signal electrodes 12 and the ground electrodes 13, respectively. The ground conductor 112g is positioned at the bottom of each second groove 112. With this configuration, the dielectric constant between the signal electrodes 12 and the ground electrodes 13 can be reduced, and the risk of a drop in the characteristic impedance of the radio-frequency signal lines can be suppressed.

Each pair of signal electrodes 12 includes the leads 12a. In plan view of the first surface 10a, each lead 12a overlaps at least part of the corresponding first via-hole conductor 141. Thus, transmission of signals along the first surface 10a can be suppressed as much as possible between the lead 12a and the first via-hole conductor 141, and signal loss, particularly in a radio-frequency band, can be further reduced.

The semiconductor electronic device 1 of this embodiment includes the above-described semiconductor package 6, the electronic component 7 electrically connected to a pair of differential lines 14, and the lid 8. According to this semiconductor electronic device 1, signals output from the electronic component 7 and/or signals input to the electronic component 7 can be transmitted even if the signals are of a higher frequency than was previously possible.

The above embodiment is a merely an example, and various changes are possible. For example, in the above embodiment, the insulating substrate 11 is described as being manufactured by stacking, pressure bonding, and firing ceramic green sheets, but is not limited to being manufactured in this way. The insulating substrate 11 may be fabricated using other method so long as the differential lines 14 are properly positioned thereinside.

The position of the tip of the first groove 111 does not need to be closer to the edge 10b than the position of the tip of the signal electrode 12 as illustrated in the above embodiment. If there are no issues with respect to size, for example, the position of the tip of the first groove 111 may be somewhat farther from the edge 10b than the position of the tip of the signal electrode 12 is.

The first groove 111 does not need to contact the edge 10b. In other words, the first groove 111 may be shaped like a hole and positioned inside the first surface 10a. The hole-like shape is not particularly limited, and may be, for example, elliptical.

The first groove 111 does not need to have a shape obtained by combining the base portion 111a with the projecting portion 111b as described above. For example, the projecting portion 111b may have a triangular shape. Alternatively, an integrated tapered shape or the like may be used without being divided into the base portion 111a and the projecting portion 111b.

The gap region 11f may be positioned separately for each of the pairs of differential lines 14, or may be commonly provided for multiple pairs of differential lines 14.

The shape of the gap region 11f is not limited to the ellipsoidal shape described above. For example, a dumbbell-like shape may be used in which a rectangular portion connecting the inner edges of a pair of ground via-hole conductors 145 to each other decrease in width down to a width that is smaller than the diameter of the coaxial structure. The shape may be somewhat out of alignment with the inner edge of the ground via-hole conductor 145, which forms a coaxial structure, and, for example, may be polygonal shape such as a rectangular shape.

In the above embodiment, the first via-hole conductor 141 is described as overlapping the lead 12a by around half in plan view, but may instead overlap the lead 12a to a different extent, for example, the entire first via-hole conductor 141 may overlap the lead 12a.

The above embodiment is described as having a structure in which the ground electrodes 13 are disposed on both sides of the signal electrodes 12 (GSSG structure) and including the second grooves 112 between the signal electrodes 12 and the ground electrodes 13, but is not limited to this configuration. The second grooves 112 do not need to be included or the positions of the ground electrodes 13 may be different.

The shape of the semiconductor package 6 described in the above embodiment is not limited to the described shape. For example, the second surface 10c, which is at a higher position than the third surface 10d, does not need to be flat and may include portions having multiple heights. The entire first surface 10a does not need to be constituted by the wiring substrate 10, and part of the first surface 10a may be made up of a separate bottom plate or the like.

In the above embodiment, the differential lines 14 are described as extending in the x direction and the z-plane direction except for in the areas where the spacing is adjusted as illustrated in Modifications 1 and 2, but may also include components that extend in the y direction.

In Modification 1, the wide portion 1421 is described as spanning the entirety of an area from the boundary position of the ground plane 11g to the position of the connection of the first signal line 142a to the first via-hole conductor 141 in planar perspective view, but is not limited to this configuration. As illustrated in FIG. 7B, the characteristic impedance is improved, even if only part of the range. The wide portion 1421 does not need to extend to a position where the wide portion 1421 overlaps the ground plane 11g in planar perspective view, but does not need to be configured with no overlapping parts.

The wide portion 1421 is not limited to a configuration where the wide portion 1421 extends only on the opposite side from the first groove 111 in planar perspective view. The wide portion 1421 may extend on the side where the first groove 111 is located, for example, to the extent that the wide portion does not overlap the ground conductor 111g in planar perspective view.

The semiconductor package 6 described above may be manufactured and sold separately from the electronic component 7. In this case, the lid 8 may be sold without having been bonded to the frame 20. The semiconductor package 6 does not need to include the frame 20. The semiconductor electronic device 1 does not need to include the lid 8. Other specific configurations, positional relationships, materials, and so forth illustrated in the above embodiment can be changed as appropriate without departing from the gist of the present disclosure. The scope of the present invention includes the scope of the claims and their equivalents.

### INDUSTRIAL APPLICABILITY

The present invention can be used in semiconductor packages and semiconductor electronic devices.

## Claims

1. A semiconductor package comprising:
an insulating substrate having a first surface and a second surface on an opposite side from the first surface;
a pair of first electrodes disposed side by side along one edge of the first surface;
a pair of differential lines that are respectively electrically connected to the pair of first electrodes and are configured to carry signals; and
a ground conductor,
wherein the insulating substrate includes a first groove located in the first surface and extending between the pair of first electrodes,
each of the pair of differential lines includes
a first signal line located inside the insulating substrate and extending along the first surface,
a second signal line located on the second surface,
a first connection conductor electrically connecting the first electrode and the first signal line to each other inside the insulating substrate, and
a second connection conductor located between the first signal line and the second signal line inside the insulating substrate,
the ground conductor includes
a first ground plane located on the first surface,
an inside-first-groove ground plane located at a bottom of the first groove,
a second ground plane located inside the insulating substrate with the first signal line interposed between the second ground plane and the first surface, and
a ground connection conductor located along the second connection conductor inside the insulating substrate,
part of the ground connection conductor is located around the second connection conductor and forms a coaxial structure together with the second connection conductor,
the first signal line forms a stripline structure in a region where the first signal line faces the first ground plane and the second ground plane, and
in planar perspective view of the first surface, a position on the first surface including an end portion of the second connection conductor on an opposite side from a point of contact with the second signal line is located in a gap region that does not contain the first ground plane.

2. The semiconductor package according to claim 1,
wherein a furthest position of the inside-first-groove ground plane from the one edge is closer to the one edge than a furthest position of the first electrode from the one edge is in plan view of the first surface.

3. The semiconductor package according to claim 2,
wherein the first groove includes a base portion and a projecting portion located at another end of the first groove on an opposite side from the one edge and having a smaller width in a direction perpendicular to an extension direction of the first groove than the base portion.

4. The semiconductor package according to any one of claims 1 to 3,
wherein a first end portion of the first signal line on an opposite side from a point of contact with the first connection conductor and a second end portion of the second connection conductor on an opposite side from a point of contact with the second signal line are directly connected to each other.

5. The semiconductor package according to any one of claims 1 to 4,
wherein the first signal line includes a wide portion in which a line width of part of the first signal line is wider in a direction perpendicular to an extension direction of the first signal line in a region that does not overlap the first ground plane and is different from the gap region in planar perspective view of the first surface.

6. The semiconductor package according to claim 5,
wherein the wide portion extends across an entire area between a position where the first signal line is connected to the first connection conductor and a boundary of a region where the first signal line overlaps the first ground plane in planar perspective view of the first surface.

7. The semiconductor package according to claim 5 or 6,
wherein the wide portion has a wider width on an opposite side from the first groove in planar perspective view of the first surface.

8. The semiconductor package according to any one of claims 1 to 3,
wherein a first end portion of the first signal line on an opposite side from a point of contact with the first connection conductor is positioned closer to the first surface and closer to the first connection conductor in planar perspective view of the first surface than a second end portion of the second connection conductor on an opposite side from a point of contact with the second signal line is, and the first end portion and second end portion are connected to each other by a third connection conductor parallel to the first connection conductor and a third signal line parallel to the first signal line.

9. The semiconductor package according to claim 8,
wherein multiple pairs of the third connection conductor and the third signal line, which are connected to each other at ends thereof, are connected in series with each other, and
a ratio of a length of the third connection conductor to a length of the third signal line is greater than a ratio of a length of the first connection conductor to a length of the first signal line, and this ratio becomes larger the closer each pair is to the second end portion.

10. The semiconductor package according to claim 8 or 9,
wherein a spacing of the first signal lines in the differential lines is smaller than a spacing of the second signal lines.

11. The semiconductor package according to any one of claims 8 to 10,
wherein a position of the third connection conductor in planar perspective view is contained in the gap region.

12. The semiconductor package according to any one of claims 1 to 7,
wherein the gap region for the pair of differential lines is formed of a single connected region.

13. The semiconductor package according to any one of claims 8 to 11,
wherein the gap regions are separated from each other for each second connection conductor.

14. The semiconductor package according to any one of claims 1 to 13, wherein an outer edge of the gap region overlaps an inner edge of the ground connection conductor, which forms the coaxial structure, in planar perspective view of the first surface.

15. The semiconductor package according to any one of claims 1 to 14, further comprising:
a pair of second electrodes positioned on opposite sides of the pair of first electrodes from the first groove in a direction along the one edge and electrically connected to the first ground plane,
wherein the insulating substrate includes second grooves positioned between the first electrodes and the second electrodes, and
the ground conductor includes a inside-second-groove ground plane located at bottoms of the second grooves.

16. The semiconductor package according to any one of claims 1 to 15,
wherein each of the pair of first electrodes includes a conductor connection portion,
and
the conductor connection portions each overlap at least part of the corresponding first connection conductor in plan view of the first surface.

17. A semiconductor electronic device comprising:
the semiconductor package according to any one of claims 1 to 16; and
an electronic component electrically connected to the pair of differential lines.
